# EUROPEAN PATENT SPECIFICATION

(11) **EP 1 952 899 B1**
(45) Date of publication and mention of the grant of the patent: **13.01.2010**
(21) Application number: 08001588.6
(22) Date of filing: 29.01.2008
(51) Int. Cl.: B08B 3/02, H01L 21/00

(54) **Substrate cleaning apparatus, substrate cleaning method, and storage medium**
Vorrichtung und Verfahren zur Substratreinigung sowie Speichermedium
Appareil de nettoyage de substrat, procédé de nettoyage de substrat, et support de stockage

(30) Priority: 31.01.2007 JP 2007022004
(43) Date of publication of application: 06.08.2008
(73) Proprietor: Tokyo Electron Ltd., Tokyo-to (JP)
(72) Inventor: Hiroshiro, Koukichi, Tosu-shi, Saga-ken (JP); Toshima, Takayuki, Koshi-shi Kumamoto-ken (JP)
(74) Representative: HOFFMANN EITLE

(56) References cited:
- EP-A- 1 505 642
- US-A1- 2004 154 641
- US-A1- 2004 159 335
- US-A1- 2006 081 180
- US-B1- 6 378 534

## Description

### FIELD OF THE INVENTION

The present invention relates to a substrate cleaning apparatus, a substrate cleaning method, and a storage medium. In particular, the present invention pertains to a substrate cleaning apparatus, a substrate cleaning method, and a storage medium, for cleaning a substrate with a use of a cleaning agent which is generated by reacting plural kinds of chemical liquids.

### BACKGROUND ART

When a semiconductor part, a flat display panel, an electronic part, and so on are manufactured, a substrate cleaning apparatus has been conventionally used for cleaning a substrate such as a semiconductor wafer, a liquid crystal substrate, a disc-shaped storage medium, and so on. When a substrate is cleaned by such a substrate cleaning apparatus, an oxide film and a resist film generated on a surface of the substrate can be removed.

In such a conventional substrate cleaning apparatus, it is conventional that plural kinds of heated chemical liquids are reacted to generate a cleaning agent, and that a surface of a substrate is cleaned by supplying the cleaning agent to the surface of the substrate.

For example, in a substrate cleaning apparatus disclosed in JP2006-278509A, Caro's acid (H₂SO₅: peroxomonosulfuric acid) is generated by reacting heated sulfuric acid and hydrogen peroxide solution (H₂SO₄ + H₂O₂ → H₂SO₅ + H₂O), and the Caro's acid is supplied onto a surface of a substrate. In this type of substrate cleaning apparatus, the surface of the substrate is cleaned by an oxidation ability of the Caro's acid.

US 2006/0081180 A1 relates to a substrate processing apparatus including a substrate mounting table that rotates with a semiconductor substrate retained thereon, a first container that stores a first liquid to be supplied to a surface of the semiconductor substrate, a second container that stores a second liquid to be supplied to the surface of the semiconductor substrate, a mixing unit connecting the first container and the second container so as to mix the first liquid and the second liquid supplied from the first and the second containers thus to give a mixed solution, and a nozzle connecting the mixing unit so as to supply the mixed solution to the surface of the semiconductor substrate.

US 2004/0154641 A1 relates to a substrate processing apparatus and method for removing materials from a substrate contained in a closed, pressurized processing vessel.

EP 1 505 642 A2 relates to a method and apparatus for manufacturing semiconductor devices and, in particular, to a method and an apparatus for cleaning an etched target.

US 6,378,534 B1 relates to a semiconductor wafer cleaning system according to which semiconductor wafers are positioned in a cleaning tank and subjected to sequential flows of one or more highly diluted cleaning solutions that are injected into the lower end of the tank and allowed to overflow at the upper end.

### DISCLOSURE OF THE INVENTION

In the above-described conventional substrate cleaning apparatus, plural kinds of heated chemical liquids (e.g., sulfuric acid and hydrogen peroxide solution) are reacted to generate a cleaning agent (e.g., Caro's acid), and then a surface of a substrate is cleaned by supplying the cleaning agent to the surface of the substrate. Thus, there arises a problem in that, when the cleaning agent is generated by reacting the chemical liquids, the chemical liquid are evaporated and/or degraded by a heat from outside and/or by a reaction heat caused by the reaction of the chemical liquids. When the chemical liquids are evaporated and/or degraded, there is a possibility that a desired amount of the cleaning agent of a desired concentration is not generated, and thus a substrate may not be appropriately cleaned.

Particularly in a substrate cleaning apparatus that cleans a substrate by use of a sulfuric acid / hydrogen peroxide mixture (SPM), the hydrogen peroxide solution is heated by, in addition to the heat from outside and the reaction heat, a heat of dilution caused by dilution of the sulfuric acid. As a result, the hydrogen peroxide solution degrades and foams, whereby an amount of the hydrogen peroxide solution, which contributes to generation of Caro's acid, is decreased. In this case, there is a possibility that a sufficient amount of Caro's acid for cleaning of a substrate is not generated, and thus a substrate may not be appropriately cleaned.

The present invention has been made in view of the foregoing circumstances. The object of the present invention is to provide a substrate cleaning apparatus, a substrate cleaning method, and a storage medium, which are capable of appropriately clean a substrate.

The substrate cleaning apparatus according to the present invention is a substrate cleaning apparatus for cleaning a substrate with the use of a cleaning agent that is generated by reacting plural kinds of chemical liquids, the substrate cleaning apparatus comprising: a mixing unit for mixing plural kinds of chemical liquids; a supplying unit for supplying the chemical liquids that have been mixed by the mixing unit, onto a surface of a substrate to be cleaned; and a heating unit for heating the chemical liquids that have been supplied onto the surface of the substrate by the supplying unit, on the surface of the substrate.

In the above-described substrate cleaning apparatus, it is preferable that the mixing unit includes a reaction restraining mechanism for restraining a reaction of the mixed chemical liquids. It is more preferable that the reaction restraining mechanism is a cooling mechanism for cooling the mixed chemical liquids.

The substrate cleaning apparatus according to the present invention is a substrate cleaning apparatus for cleaning a substrate with the use of a reaction product that is generated by reacting sulfuric acid and hydrogen peroxide solution, the substrate cleaning apparatus comprising: a mixing unit for mixing sulfuric acid and hydrogen peroxide solution to generate a sulfuric acid / hydrogen peroxide mixture (SPM); a supplying unit for supplying the sulfuric acid / hydrogen peroxide mixture that has been generated by the mixing unit, onto a surface of a substrate to be cleaned, and a heating unit for heating the sulfuric acid / hydrogen peroxide mixture that has been supplied onto the surface of the substrate by the supplying unit, on the surface of the substrate.

In the above-described substrate cleaning apparatus, it is preferable that the mixing unit includes a temperature-rise restraining mechanism for restraining rise in temperatures of the mixed sulfuric acid and the hydrogen peroxide solution. It is more preferable that the temperature-rise restraining mechanism is configured to gradually mix the sulfuric acid and the hydrogen peroxide solution so as to maintain a state in which the hydrogen peroxide solution does not foam.

Alternatively, the temperature-rise restraining mechanism may be a cooling mechanism for cooling the mixed sulfuric acid and the hydrogen peroxide solution. In this case, it is preferable that the cooling mechanism is configured to cool the mixed sulfuric acid and the hydrogen peroxide solution to a temperature at which the hydrogen peroxide solution does not foam.

In the above-described substrate cleaning apparatus, the reaction product may be Caro's acid (H₂SO₅: peroxomonosulfuric acid).

The substrate cleaning method according to the present invention is a substrate cleaning method for cleaning a substrate with the use of a cleaning agent that is generated by reacting plural kinds of chemical liquids, the substrate cleaning method comprising the steps of: mixing plural kinds of chemical liquids; supplying the mixed chemical liquids onto a surface of a substrate to be cleaned; and heating the chemical liquids that have been supplied onto the surface of the substrate, on the surface of the substrate.

In the above-described substrate cleaning method, it is preferable that, at the step of mixing the plural kinds of chemical liquids, a reaction of the plural kinds of chemical liquids is restrained.

In the above-described substrate cleaning method, it is preferable that, at the step of mixing the plural kinds of chemical liquids, a reaction of the plural kinds of chemical liquids is restrained by cooling the plural kinds of chemical liquids.

The substrate cleaning method according to the present invention is a substrate cleaning method for cleaning a substrate with the use of a reaction product that is generated by reacting sulfuric acid and hydrogen peroxide solution, the substrate cleaning method comprising the steps of: mixing sulfuric acid and hydrogen peroxide solution to generate a sulfuric acid / hydrogen peroxide mixture; supplying the sulfuric acid / hydrogen peroxide mixture that has been generated, onto a surface of a substrate to be cleaned; and heating the sulfuric acid / hydrogen peroxide mixture that has been supplied onto the surface of the substrate, on the surface of the substrate.

In the above-described substrate cleaning method, it is preferable that, at the step of mixing the sulfuric acid and the hydrogen peroxide solution, rise in temperatures of the mixed sulfuric acid and the hydrogen peroxide solution is restrained.

In the above-described substrate cleaning method, it is preferable that, at the step of mixing the sulfuric acid and the hydrogen peroxide solution, rise in temperatures of the sulfuric acid and the hydrogen peroxide solution is restrained by gradually mixing the sulfuric acid and the hydrogen peroxide solution so as to maintain a state in which the hydrogen peroxide solution does not foam.

In the above-described substrate cleaning method, it is preferable that, at the step of mixing the sulfuric acid and the hydrogen peroxide solution, rise in temperatures of the sulfuric acid and the hydrogen peroxide solution by cooling the mixed sulfuric acid and the hydrogen peroxide solution.

In the above-described substrate cleaning method, it is preferable that, at the step of mixing the sulfuric acid and the hydrogen peroxide solution, rise in temperatures of the sulfuric acid and the hydrogen peroxide solution is restrained by cooling the mixed sulfuric acid and the hydrogen peroxide solution to a temperature at which the hydrogen peroxide solution does not foam.

In the above-described substrate cleaning method, the reaction product may be Caro's acid.

The storage medium according to the present invention is a storage medium storing a substrate cleaning program for allowing a substrate cleaning apparatus for cleaning a substrate with the use of a cleaning agent that is generated by reacting plural kinds of chemical liquids to perform a substrate cleaning operation, the substrate cleaning program comprising the steps of: mixing plural kinds of chemical liquids; supplying the mixed chemical liquids onto a surface of a substrate to be cleaned; and heating the chemical liquids that have been supplied onto the surface of the substrate, on the surface of the substrate.

In the above-described storage medium, it is preferable that, at the step of mixing the plural kinds of chemical liquids in the substrate cleaning program, a reaction of the plural kinds of chemical liquids is restrained.

In the above-described storage medium, it is preferable that, at the step of mixing the plural kinds of chemical liquids in the substrate cleaning program, a reaction of the plural kinds of chemical liquids is restrained by cooling the plural kinds of chemical liquids.

The storage medium according to the present invention is a storage medium storing a substrate cleaning program for allowing a substrate cleaning apparatus for cleaning a substrate with the use of a reaction product that is generated by reacting sulfuric acid and hydrogen peroxide solution, the substrate cleaning program comprising the step of: mixing sulfuric acid and hydrogen peroxide solution to generate a sulfuric acid / hydrogen peroxide mixture; supplying the sulfuric acid / hydrogen peroxide mixture that has been generated, onto a surface of a substrate to be cleaned; and heating the sulfuric acid / hydrogen peroxide mixture that has been supplied onto the surface of the substrate, on the surface of the substrate.

In the above-described storage medium, it is preferable that, at the step of mixing the sulfuric acid and the hydrogen peroxide solution in the substrate cleaning program, rise in temperatures of the mixed sulfuric acid and the hydrogen peroxide solution is restrained.

In the above-described storage medium, it is preferable that, at the step of mixing the sulfuric acid and the hydrogen peroxide solution in the substrate cleaning program, rise in temperatures of the sulfuric acid and the hydrogen peroxide solution is restrained by gradually mixing the sulfuric acid and the hydrogen peroxide solution so as to maintain a state in which the hydrogen peroxide solution does not foam.

In the above-described storage medium, it is preferable that, at the step of mixing the sulfuric acid and the hydrogen peroxide solution in the substrate cleaning program, rise in temperatures of the sulfuric acid and the hydrogen peroxide solution by cooling the mixed sulfuric acid and the hydrogen peroxide solution.

In the above-described storage medium, it is preferable that, at the step of mixing the sulfuric acid and the hydrogen peroxide solution in the substrate cleaning program, rise in temperatures of the sulfuric acid and the hydrogen peroxide solution is restrained by cooling the mixed sulfuric acid and the hydrogen peroxide solution to a temperature at which the hydrogen peroxide solution does not foam.

In the above-described storage medium, the reaction product may be Caro's acid.

The present invention produces the following effects.

Namely, in the present invention, after the plural kinds of chemical liquids are mixed, the mixed chemical liquids are heated on the surface of the substrate. Thus, evaporation and/or alteration of the chemical liquids while being mixed can be prevented, and a desired amount of the cleaning agent of a desired concentration can be generated. Therefore, the substrate can be appropriately cleaned. In addition, since the mixed chemical liquids are heated on the surface of the substrate, a reaction of the chemical liquids is promoted so that the cleaning agent is generated on the surface of the substrate by the reaction of the chemical liquids. Therefore, the substrate can be appropriately cleaned.

In particular, when a substrate is cleaned by use of a sulfuric acid / hydrogen peroxide mixture (SPM) in which sulfuric acid and hydrogen peroxide solution are mixed, the hydrogen peroxide is prevented from degrading and foaming. Since a reaction product (e.g., Caro's acid) having a high oxidation ability can be generated on a surface of the substrate, the surface of the substrate can be appropriately cleaned by this reaction product.

### BRIEF DESCRIPTION OF THE DRAWINGS

Fig. 1 is a schematic side view of a substrate cleaning apparatus according to the present invention;
Fig. 2 is a plan view of the substrate cleaning apparatus shown in Fig. 1;
Fig. 3 is a diagrammatic view of a cleaning liquid ejecting unit in the substrate cleaning apparatus shown in Fig. 1;
Fig. 4 is a diagrammatic view of another cleaning liquid ejecting unit in a substrate cleaning apparatus according to the present invention; and
Fig. 5 is a flowchart of a substrate cleaning program executed in the substrate cleaning apparatus shown in Fig. 1.

### DETAILED DESCRIPTION OF THE PREFERRED EMBODIMENT

Concrete structures of a substrate cleaning apparatus, a substrate cleaning method, and a storage medium according to the present invention will be described below with reference to the drawings. In the following description, the present invention is described as applied to a substrate cleaning apparatus that cleans a wafer.

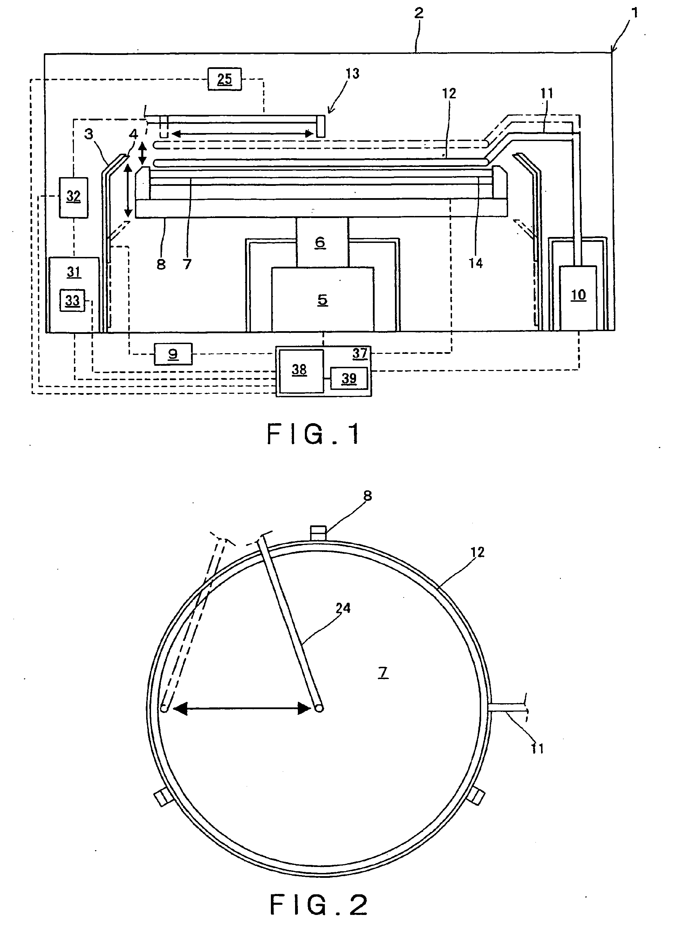

A structure of a substrate cleaning apparatus is described at first. As shown in Fig. 1, a substrate cleaning apparatus 1 comprises a chamber 2, and a cylindrical outer cup 3 disposed in the chamber 2. An inner cup 4 capable of vertically moving is disposed in the outer cup 3. A rotation motor 5 is arranged on a center part inside the inner cup 4. Attached to a distal end of a driving shaft 6 of the rotation motor 5 is a spin chuck 8 that holds and horizontally rotates a wafer 7. An elevating mechanism 9 is connected to the inner cup 4.

As shown in Figs. 1 and 2, an elevating mechanism 10 is provided outside the outer cup 3. A proximal end of an elevating arm 11 is attached to the elevating mechanism 10, and an annular ring 12 is attached to a distal end of the elevating arm 11. Thus, the ring 12 can be vertically moved above the wafer 7 by the elevating mechanism 10.

Further, the substrate cleaning apparatus 1 is provided with a cleaning liquid ejecting unit 13 for ejecting a cleaning liquid onto a surface of the wafer 7, and a heating unit 14 for heating the chemical liquid ejected on the surface of the wafer 7.

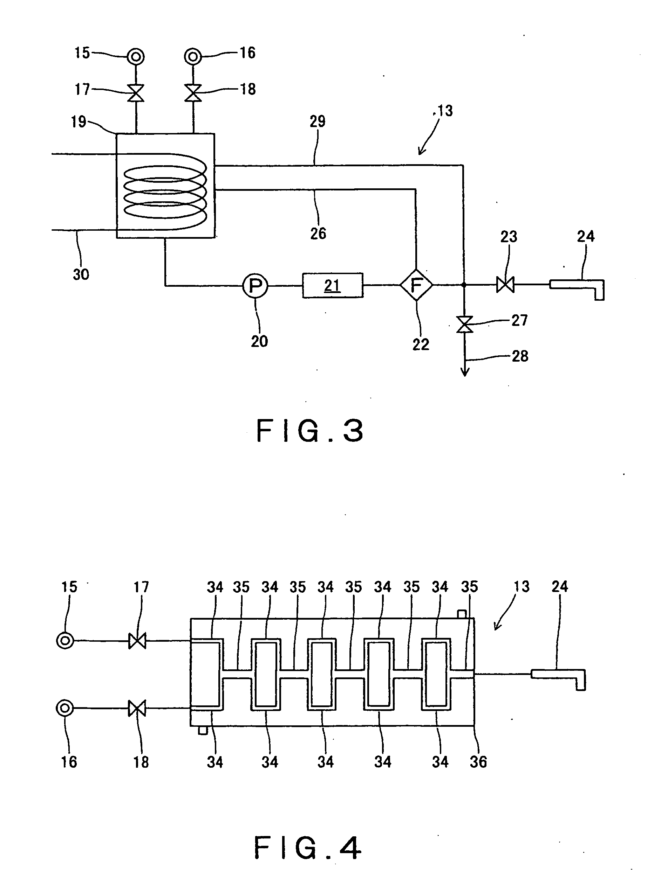

As shown in Figs. 1 and 3, the chemical liquid ejecting unit 13 includes a supply source 15 of sulfuric acid, a supply source 16 of hydrogen peroxide solution, and a mixing bath 19. The supply source 15 of sulfuric acid is connected to the mixing bath 19 via an on-off valve 17, and the supply source 16 of hydrogen peroxide solution is connected to the mixing bath 19 via an on-off valve 18. A pump 20 is connected to the mixing bath 19. A temperature adjusting device 21 is connected to the pump 20. A filter 22 is connected to the temperature adjusting device 21. A nozzle 24 is connected to the filter 22 via an on-off valve 23. A moving mechanism 25 is connected to the nozzle 24. The moving mechanism 25 is capable of moving the nozzle 24 above the wafer 7 along a radial direction of the wafer 7.

A chemical liquid containing sulfuric acid and hydrogen peroxide (e.g., SPM) is likely to adsorb moisture in an atmosphere. Thus, in the chemical liquid containing sulfuric acid and hydrogen peroxide, there is a possibility that an optimum value of a mixture ratio of the sulfuric acid and the hydrogen peroxide solution is changed by the adsorption of moisture in the atmosphere, which results in deterioration in cleaning ability (specifically, resist removal ability). Therefore, the mixing bath 19 and a storage bath used in the supply source 15 of sulfuric acid are preferably structured such that a dry inert gas is supplied to a liquid surface so as to prevent adsorption of moisture.

In the chemical liquid ejecting unit 13, the filter 22 and the mixing bath 19 are connected to each other through an overflow pipe 26. A drain pipe 28 is connected to an outlet port of the filter 22 via an on-off valve 27. The outlet port of the filter 22 is connected to the mixing bath 19 through a circulating pipe 29.

Further, in the chemical liquid ejecting unit 13, a cooling mechanism 30 is disposed in the mixing bath 19.

In the chemical liquid ejecting unit 13, by opening the respective on-off valves 17 and 18 to supply sulfuric acid and hydrogen peroxide solution into the mixing bath 19, the sulfuric acid and the hydrogen peroxide solution can be mixed in the mixing bath 19. In addition, by driving the pump 20 while the on-off valves 23 and 27 are closed, the sulfuric acid and the hydrogen peroxide solution can be mixed. Thus, the chemical liquid ejecting unit 13 functions as a mixing unit 31 for mixing sulfuric acid and hydrogen peroxide solution so as to generate a sulfuric acid / hydrogen peroxide mixture (SPM).

In the chemical liquid ejecting unit 13, by driving the pump 20 while the on-off valve 23 is opened and the on-off valve 27 is closed, the sulfuric acid / hydrogen peroxide mixture can be supplied from the mixing bath 19 onto a surface of the wafer 7 through the nozzle 24. Thus, the chemical liquid ejecting unit 13 functions as a supplying unit 32 for supplying the sulfuric acid / hydrogen peroxide mixture onto the surface of the wafer 7.

In addition, the chemical liquid ejecting unit 13 functions as a temperature-rise restraining mechanism that restrains rise in temperatures of the sulfuric acid and the hydrogen peroxide solution, by cooling the hydrogen peroxide solution by the cooling mechanism 30. In the chemical liquid ejecting unit 13, since rise in temperatures of the sulfuric acid and the hydrogen peroxide solution is restrained, a reaction of the sulfuric acid and the hydrogen peroxide solution can be restrained. Thus, the chemical liquid ejecting unit 13 functions as a reaction restraining mechanism 33 for restraining the reaction of the sulfuric acid and the hydrogen peroxide solution to generate Caro's acid as a reaction product. It is not necessary that the reaction restraining mechanism 33 completely inhibits the reaction of the sulfuric acid and the hydrogen peroxide solution. It is sufficient to restrain generation of a reaction product caused by the reaction of the sulfuric acid and the hydrogen peroxide solution, or to restrain degradation of the reaction product.

The cleaning liquid ejecting unit 13 may be structured as shown in Fig. 4. Namely, the supply source 15 of sulfuric acid and the supply source 16 of hydrogen peroxide solution are respectively connected, via the on-off valves 17 and 18, to branching pipes 34 of a smaller diameter which are arranged in parallel. Then, the branching pipes 34 arranged in parallel and mixing pipes 35 having a larger diameter than that of the branching pipe 34 are serially arranged such that the branching pipes 34 and the mixing pipes 35 are alternately arranged in a repeated manner. Finally, the nozzle 24 is connected to the mixing pipe 35, and the plurality of branching pipes 34 and the mixing pipes 35 are accommodated in a cooling vessel 36. In the cooling vessel 36, the sulfuric acid / hydrogen peroxide mixture in which the sulfuric acid and the hydrogen peroxide solution are mixed is passed and cooled.

Also in this case, by opening the respective on-off valves 17 and 18, the sulfuric acid and the hydrogen peroxide solution can be mixed in the branching pipes 34 and the mixing pipes 35. Thus, the chemical liquid ejecting unit 13 functions as the mixing unit 31 for mixing the sulfuric acid and the hydrogen peroxide solution so as to generate the sulfuric acid / hydrogen peroxide mixture. In addition, by opening the respective on-off valves 17 and 18, the sulfuric acid / hydrogen peroxide mixture can be supplied onto the surface of the wafer 7 through the nozzle 24. Thus, the chemical liquid ejecting unit 13 functions as the supplying unit 32 for supplying the sulfuric acid / hydrogen peroxide mixture onto the surface of the wafer 7.

In addition, the chemical liquid ejecting unit 13 functions as a temperature-rise restraining mechanism that restrains rise in temperatures of the sulfuric acid and the hydrogen peroxide solution, by cooling the sulfuric acid / hydrogen peroxide mixture passing through the branching pipes 34 and the mixing pipes 35 in the cooling vessel 36. In the chemical liquid ejecting unit 13, since rise in temperatures of the sulfuric acid and the hydrogen peroxide solution is restrained, the reaction of the sulfuric acid and the hydrogen peroxide solution can be restrained. Thus, the chemical liquid ejecting unit 13 functions as a reaction restraining mechanism 33 for restraining the reaction of the sulfuric acid and the hydrogen peroxide solution to generate Caro's acid as a reaction product. It is not necessary that the reaction restraining mechanism 33 completely inhibits the reaction of the sulfuric acid and the hydrogen peroxide solution. It is sufficient to restrain generation of a reaction product caused by the reaction of the sulfuric acid and the hydrogen peroxide solution, or to restrain degradation of the reaction product.

The heating unit 14 is located above the spin chuck 8. The heating unit 14 directly heats the wafer 7 to heat the sulfuric acid / hydrogen peroxide mixture that has been supplied onto the surface of the wafer 7. Thus, the reaction of the sulfuric acid and the hydrogen peroxide solution is promoted on the surface of the wafer 7 so as to generate Caro's acid. Herein, the wafer 7 is directly heated to heat the sulfuric acid / hydrogen peroxide mixture. However, the wafer 7 may not be directly heated, but the sulfuric acid / hydrogen peroxide mixture that has been supplied onto the wafer 7 may be directly heated by a heater disposed in the chamber 2.

In the substrate cleaning apparatus 1, a control device 37 is connected to the respective driving units, such as the rotation motor 5, the elevating mechanism 9, the elevating mechanism 10, the cleaning liquid ejecting unit 13 (specifically, the on-off valves 17, 18, 23, and 27, the pump 20, the moving mechanism 25, the cooling mechanism 30, the mixing unit 31, the supplying unit 32, and the reaction restraining mechanism 33), and the heating unit 14. Thus, driving of each driving unit is controlled by the control device 37.

The control device 37 includes a controller 38 formed of a CPU, and a storage medium 39 connected to the controller 38. The storage medium 39 stores various set data and a substrate cleaning program 40 which is described below. The storage medium 39 may be a memory such as a ROM or RAM, or may be a hard disc or a disc-shaped storage medium such as a CD-ROM.

A substrate cleaning method carried out by the substrate cleaning apparatus 1 as structured above is described below. In a cleaning operation of a substrate by the substrate cleaning apparatus 1, the substrate cleaning program 40 stored in the storage medium 39 of the control device 37 is executed to carry out cleaning of a substrate by the substrate cleaning apparatus 1.

The substrate cleaning program 40 includes a mixing step S1 in which sulfuric acid and hydrogen peroxide solution are mixed to generate a sulfuric acid / hydrogen peroxide mixture, a supplying step S2 in which the sulfuric acid / hydrogen peroxide mixture is supplied onto a surface of the wafer 7, and a heating step S3 in which the sulfuric acid / hydrogen peroxide mixture that has been supplied onto the surface of the wafer 7 is heated to generate Caro's acid.

In the mixing step S1, sulfuric acid and hydrogen peroxide solution are mixed in the mixing bath 19. To be specific, the control device 37 opens the respective on-off valves 17 and 18 to supply sulfuric acid and hydrogen peroxide solution from the supply sources 15 and 16 into the mixing bath 19, so that the sulfuric acid and the hydrogen peroxide solution are mixed in the mixing bath 19. In addition, the control device 37 drives the pump 20 while the on-off valves 23 and 27 are closed, so as to mix the sulfuric acid and the hydrogen peroxide solution in the mixing bath 19, whereby the sulfuric acid and the hydrogen peroxide solution are mixed to generate a sulfuric acid / hydrogen peroxide mixture.

In the mixing step S1, when the sulfuric acid and the hydrogen peroxide solution are mixed, rise in temperatures of the sulfuric acid and the hydrogen peroxide solution is restrained. Thus, it is possible to restrain generation of Caro's acid caused by a reaction of the sulfuric acid and the hydrogen peroxide solution, or to restrain degradation of the Caro's acid which has been generated by the reaction of the sulfuric acid and the hydrogen peroxide solution.

To be specific, at the mixing step S1, when the sulfuric acid and the hydrogen peroxide solution are mixed, only the sulfuric acid is previously stored in the mixing bath 19, and thereafter the hydrogen peroxide solution is gradually supplied into the mixing bath 19. By gradually mixing the sulfuric acid and the hydrogen peroxide solution in the mixing bath 19 so as to maintain a state in which the hydrogen peroxide solution does not foam, rise in temperatures of the sulfuric acid and the hydrogen peroxide can be restrained. Thus, it is possible to restrain generation of Caro's acid caused by a reaction of the sulfuric acid and the hydrogen peroxide solution, or to restrain degradation of the Caro's acid which has been generated by the reaction of the sulfuric acid and the hydrogen peroxide solution. Alternatively, only the hydrogen peroxide solution may be previously stored in the mixing bath 19, and thereafter the sulfuric acid may be gradually supplied into the mixing bath 19.

Moreover, at the mixing step S1, when the sulfuric acid and the hydrogen peroxide solution are mixed, by driving the cooling mechanism 30 in the mixing bath 19 to cool the sulfuric acid and the hydrogen peroxide solution, rise in temperatures of the sulfuric acid and the hydrogen peroxide solution can be restrained. Thus, it is possible to restrain generation of Caro's acid caused by a reaction of the sulfuric acid and the hydrogen peroxide solution, or to restrain degradation of the Caro's acid which has been generated by the reaction of the sulfuric acid and the hydrogen peroxide solution. In particular, when the sulfuric acid and the hydrogen peroxide solution are mixed, the sulfuric acid and the hydrogen peroxide solution are cooled to a temperature at which the hydrogen peroxide solution does not foam. In this manner, rise in temperatures of the sulfuric acid and the hydrogen peroxide is restrained. Thus, it is possible to restrain generation of Caro's acid caused by a reaction of the sulfuric acid and the hydrogen peroxide solution, or to restrain degradation of the Caro's acid which has been generated by the reaction of the sulfuric acid and the hydrogen peroxide solution.

As described above, at the mixing step S1, rise in temperatures of the sulfuric acid and the hydrogen peroxide solution is restrained so as to restrain generation of Caro's acid caused by a reaction of the sulfuric acid and the hydrogen peroxide solution, or to restrain degradation of the Caro's acid which has been generated by the reaction of the sulfuric acid and the hydrogen peroxide solution. Thus, it can be prevented that the hydrogen peroxide solution degrades and foams because of a reaction heat and/or a dilution heat of the sulfuric acid. Thus, decrease in an amount of the hydrogen peroxide, which contributes to generation of Caro's acid, can be prevented, so that a desired amount of Caro's acid can be generated on the surface of the wafer 7 at the heating step S3 which is described below. Therefore, the surface of the wafer 7 can be appropriately cleaned by the desired amount of Caro's acid.

In the mixing step S1, although the sulfuric acid and the hydrogen peroxide solution are gradually mixed while cooling the same, the present invention is not limited thereto. Namely, as long as generation of Caro's acid caused by a reaction of the sulfuric acid and the hydrogen peroxide solution can be restrained, or as long as degradation of the Caro's acid which has been generated by the reaction of the sulfuric acid and the hydrogen peroxide solution can be restrained, the sulfuric acid and the hydrogen peroxide solution may be gradually mixed without cooling the same, or the sulfuric acid and hydrogen peroxide solution may be mixed all at once while cooling the same.

Then, at the supplying step S2, the sulfuric acid / hydrogen peroxide mixture, which has been generated at the mixing step S1 by mixing the sulfuric acid and the hydrogen peroxide solution, is supplied onto the surface of the wafer 7 through the nozzle 24. To be specific, the control device 37 drives the elevating mechanism 9 to elevate the inner cup 4, and drives the rotation motor 5 to rotate the wafer 7 held on the spin chuck 8 at a lower speed. In addition, the control device 37 drives the elevating mechanism 10 to lower the ring 12 to a position close to and just above the wafer 7. Then, the control device 37 opens the on-off valve 23, and drives the pump 20 while the on-off valve 27 is closed. Thus, the sulfuric acid / hydrogen peroxide mixture is supplied from the mixing bath 19 through the nozzle 24 onto the surface of the wafer 7. At the same time, the control device 37 drives the moving mechanism 25 to move the nozzle 24 from a center part of the wafer 7 to a peripheral part thereof, so that the sulfuric acid / hydrogen peroxide mixture can be supplied over all the surface of the wafer 7.

At the supplying step S2, the sulfuric acid / hydrogen peroxide mixture supplied onto the surface of the wafer 7 is made to remain thereon. To be specific, due to the rotation of the wafer 7 at a lower speed and the provision of the ring 12, outflow of the sulfuric acid / hydrogen peroxide mixture from the periphery of the wafer 7 can be prevented to thereby save an amount of the sulfuric acid / hydrogen peroxide mixture to be used for cleaning. As long as a sufficient amount of the sulfuric acid / hydrogen peroxide mixture for cleaning the wafer 7 can be supplied onto the wafer 7, the sulfuric acid / hydrogen peroxide mixture may be gradually dropped from the nozzle 24 onto the stationary wafer 7 without the ring 12, or a large amount of sulfuric acid / hydrogen peroxide mixture may be discharged from the nozzle 24 onto the rotating wafer 7.

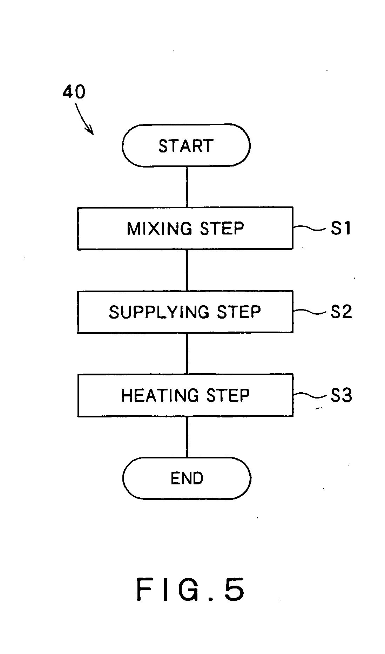

In the substrate cleaning program 40 shown in Fig. 5, after the mixing step S1 is performed, the supplying step S2 is performed. However, not limited thereto, the mixing step S1 and the supplying step S2 may be simultaneously performed.

Then, at the heating step S3, the sulfuric acid / hydrogen peroxide mixture that has been supplied onto the surface of the wafer 7 is heated on the surface of the wafer 7 so as to generate Caro's acid. To be specific, the control device 37 drives the heating unit 14 to directly heat the wafer 7 by the heating unit 14, and to heat the sulfuric acid / hydrogen peroxide mixture that has been supplied onto the surface of the wafer 7 by the heating unit 14. Thus, a reaction of the sulfuric acid and the hydrogen peroxide solution on the surface of the wafer 7 is promoted and thus Caro's acid is generated. Alternatively, the heating unit 14 heats the sulfuric acid / hydrogen peroxide mixture that has been supplied onto the surface of the wafer 7, so as to activate the Caro's acid generated by the reaction of the sulfuric acid and the hydrogen peroxide solution.

In the substrate cleaning program 40 shown in Fig. 5, after the supplying step S2 is performed, the heating step S3 is performed. However, not limited thereto, the heating step S3 may be performed simultaneously with the mixing step S1 and the supplying step S2.

As long as the substrate cleaning program 40 can promote a reaction of the sulfuric acid and the hydrogen peroxide solution by the heating operation to generate Caro's acid, or can activate the Caro's acid which has been generated by the reaction, the substrate cleaning program 40 can be variously changed. For example, at the mixing step S1, the sulfuric acid and the hydrogen peroxide solution may be cooled to a temperature at which the sulfuric acid and the hydrogen peroxide solution do not act with each other (no Caro's acid is generated), or to a temperature at which the Caro's acid generated by the reaction is not activated. Then, at the heating step S3, the sulfuric acid / hydrogen peroxide mixture may be heated so that the sulfuric acid and the hydrogen peroxide solution initially react with each other to generate Caro's acid. Alternatively, although Caro's acid is generated at the mixing step S1 by the reaction of a part of the sulfuric acid and a part of the hydrogen peroxide solution, a larger amount of Caro's acid may be generated, or the thus generated Caro's acid may be activated by heating the sulfuric acid / hydrogen peroxide mixture at the heating step S3.

It is important that, at the heating step S3, by heating the sulfuric acid / hydrogen peroxide mixture to generate Caro's acid or promote activation of the Caro's acid. Thus, degrading and foaming of the hydrogen peroxide can be prevented before the hydrogen peroxide is supplied to the wafer W, and Caro's acid having a high oxidation ability can be generated on the surface of the wafer W. Due to the oxidation ability of the Caro's acid, the surface of the wafer 7 can be appropriately cleaned.

As has been described above, in the substrate cleaning operation in the substrate cleaning apparatus 1, after plural kinds of chemical liquids (herein, sulfuric acid and hydrogen peroxide solution) are mixed, the mixed chemical liquids are heated on the surface of the wafer 7. Thus, evaporation and/or alteration of the chemical liquids while being mixed can be prevented, and a desired amount of a cleaning agent (herein, Caro's acid as a reaction product) of a desired concentration can be generated. Therefore, the wafer 7 can be appropriately cleaned. In addition, since the chemical liquids are heated, a reaction of the chemical liquids is promoted so that the cleaning agent is generated on the surface of the wafer 7 by the reaction of the chemical liquids. Therefore, the substrate can be appropriately cleaned.

It has been considered heretofore that a main reaction product generated by a reaction of sulfuric acid and hydrogen peroxide solution is Caro's acid. However, even when a reaction product, other than Caro's acid, having a high oxidation ability is generated, the present invention can be applied thereto without departing from the scope of the present invention. In addition, details of generation, degradation, and activation of Caro's acid may vary depending on various conditions. However, in the present invention, it is sufficient that, the generation, degradation, and activation of Caro's acid can be restrained when sulfuric acid and hydrogen peroxide solution are mixed at any one of the aspects of the generation, degradation, and activation of the Caro's acid, and that thereafter the generation and activation of Caro's acid can be promoted by heating a sulfuric acid / hydrogen peroxide mixture on the surface of the wafer 7 at any of the aspects of the generation and activation of Caro's acid.

In the present invention, although a concentration of hydrogen peroxide solution is not limited, hydrogen peroxide solution of not less than 35% by mass is handled as a dangerous substance. Such a hydrogen peroxide solution of not less than 35% by mass undergoes an autolysis at a temperature about 90°C. The temperature continuously rises until almost all the hydrogen peroxide degrades. In this case, the hydrogen peroxide is lost and no reaction product is generated, which results in significant decrease in a cleaning ability (resist removal ability). Therefore, as in the present invention, by supplying hydrogen peroxide solution at a lower temperature onto the surface of the wafer 7, and then by heating the hydrogen peroxide solution on the surface of the wafer 7 to a temperature not less than 90°C, the autolysis of the hydrogen peroxide solution can be prevented, while generation of a reaction product can be promoted on the upper surface of the wafer 7, to thereby improve a cleaning ability (resist removal ability).

## Claims

1. A substrate cleaning apparatus (1) for cleaning a substrate (7) with the use of a cleaning agent that is generated by reacting plural kinds of chemical liquids, the substrate cleaning apparatus comprising:
a mixing unit (19) for mixing plural kinds of chemical liquids;
a supplying unit (24) for supplying the chemical liquids that have been mixed by the mixing unit, onto a surface of a substrate to be cleaned;
a heating unit (14) for heating the chemical liquids that have been supplied onto the surface of the substrate by the supplying unit on the surface of the substrate,
**characterized in that**
the mixing unit includes a reaction restraining mechanism (33) for restraining a reaction of the mixed chemical liquids, wherein the reaction restraining mechanism functions as a temperature-rise restraining mechanism for restraining rise in temperatures of the mixed chemical liquids.

2. The substrate cleaning apparatus according to claim 1, wherein
the temperature-rise restraining mechanism is a cooling mechanism for cooling the mixed chemical liquids.

3. The substrate cleaning apparatus according to claim 1, wherein
the cleaning agent is a reaction product that is generated by reacting sulfuric acid and hydrogen peroxide solution, the substrate cleaning apparatus comprising:
the mixing unit for mixing sulfuric acid and hydrogen peroxide solution to generate a sulfuric acid / hydrogen peroxide mixture (SPM);
the supplying unit for supplying the sulfuric acid / hydrogen peroxide mixture that has been generated by the mixing unit, onto a surface of a substrate to be cleaned, and
the heating unit for heating the sulfuric acid / hydrogen peroxide mixture that has been supplied onto the surface of the substrate by the supplying unit, on the surface of the substrate.

4. The substrate cleaning apparatus according to claim 3, wherein
the temperature-rise restraining mechanism is configured to gradually mix the sulfuric acid and the hydrogen peroxide solution so as to maintain a state in which the hydrogen peroxide solution does not foam.

5. The substrate cleaning apparatus according to claim 3, wherein the temperature-rise restraining mechanism is a cooling mechanism for cooling the mixed sulfuric acid and the hydrogen peroxide solution.

6. The substrate cleaning apparatus according to claim 5, wherein
the cooling mechanism is configured to cool the mixed sulfuric acid and the hydrogen peroxide solution to a temperature at which the hydrogen peroxide solution does not foam.

7. The substrate cleaning apparatus according to claim 3, wherein
the reaction product is Caro's acid.

8. A substrate cleaning method for cleaning a substrate (7) with the use of a cleaning agent that is generated by reacting plural kinds of chemical liquids, the substrate cleaning method comprising the steps of:
mixing plural kinds of chemical liquids;
supplying the mixed chemical liquids onto a surface of a substrate to be cleaned; and
heating the chemical liquids that have been supplied onto the surface of the substrate, on the surface of the substrate, **characterized in that**
at the step of mixing the plural kinds of chemical liquids, a reaction of the plural kinds of chemical liquids is restrained by restraining rise in temperatures of the mixed chemical liquids.

9. The substrate cleaning method according to claim 8, wherein
at the step of mixing the plural kinds of chemical liquids, a reaction of the plural kinds of chemical liquids is restrained by cooling the plural kinds of chemical liquids.

10. The substrate cleaning method according to claim 8, wherein the cleaning agent is a reaction product that is generated by reacting sulfuric acid and hydrogen peroxide solution, the substrate cleaning method comprising the steps of:
mixing sulfuric acid and hydrogen peroxide solution to generate a sulfuric acid / hydrogen peroxide mixture;
supplying the sulfuric acid / hydrogen peroxide mixture that has been generated, onto a surface of a substrate to be cleaned; and
heating the sulfuric acid / hydrogen peroxide mixture that has been supplied onto the surface of the substrate, on the surface of the substrate.

11. The substrate cleaning method according to claim 10, wherein
at the step of mixing the sulfuric acid and the hydrogen peroxide solution, rise in temperatures of the mixed sulfuric acid and the hydrogen peroxide solution is restrained.

12. The substrate cleaning method according to claim 10, wherein
at the step of mixing the sulfuric acid and the hydrogen peroxide solution, rise in temperatures of the sulfuric acid and the hydrogen peroxide solution is restrained by gradually mixing the sulfuric acid and the hydrogen peroxide solution so as to maintain a state in which the hydrogen peroxide solution does not foam.

13. The substrate cleaning method according to claim 10, wherein
at the step of mixing the sulfuric acid and the hydrogen peroxide solution, rise in temperatures of the sulfuric acid and the hydrogen peroxide solution is restrained by cooling the mixed sulfuric acid and the hydrogen peroxide solution to a temperature at which the hydrogen peroxide solution does not foam.

14. The substrate cleaning method according to claim 10, wherein
the reaction product is Caro's acid.

15. A storage medium storing a substrate cleaning program for allowing a substrate cleaning apparatus (1) for cleaning a substrate (7) with the use of a cleaning agent that is generated by reacting plural kinds of chemical liquids to perform a substrate cleaning operation, the substrate cleaning program comprising the steps of:
mixing plural kinds of chemical liquids;
supplying the mixed chemical liquids onto a surface of a substrate to be cleaned; and
heating the chemical liquids that have been supplied onto the surface of the substrate, on the surface of the substrate, **characterized in that**
at the step of mixing the plural kinds of chemical liquids, a reaction of the plural kinds of chemical liquids is restrained by restraining rise in temperatures of the mixed chemical liquids.

16. The storage medium according to claim 15, wherein
at the step of mixing the plural kinds of chemical liquids in the substrate cleaning program, a reaction of the plural kinds of chemical liquids is restrained by cooling the plural kinds of chemical liquids.

17. The storage medium according to claim 15, wherein the cleaning agent is a reaction product that is generated by reacting sulfuric acid and hydrogen peroxide solution, the substrate cleaning program comprising the steps of:
mixing sulfuric acid and hydrogen peroxide solution to generate a sulfuric acid / hydrogen peroxide mixture;
supplying the sulfuric acid / hydrogen peroxide mixture that has been generated, onto a surface of a substrate to be cleaned; and
heating the sulfuric acid / hydrogen peroxide mixture that has been supplied onto the surface of the substrate, on the surface of the substrate.

18. The storage medium according to claim 17, wherein
at the step of mixing the sulfuric acid and the hydrogen peroxide solution in the substrate cleaning program, rise in temperatures of the mixed sulfuric acid and the hydrogen peroxide solution is restrained.

19. The storage medium according to claim 17, wherein
at the step of mixing the sulfuric acid and the hydrogen peroxide solution in the substrate cleaning program, rise in temperatures of the sulfuric acid and the hydrogen peroxide solution is restrained by gradually mixing the sulfuric acid and the hydrogen peroxide solution so as to maintain a state in which the hydrogen peroxide solution does not foam.

20. The storage medium according to claim 17, wherein
at the step of mixing the sulfuric acid and the hydrogen peroxide solution in the substrate cleaning program, rise in temperatures of the sulfuric acid and the hydrogen peroxide solution is restrained by cooling the mixed sulfuric acid and the hydrogen peroxide solution to a temperature at which the hydrogen peroxide solution does not foam.

21. The storage medium according to claim 17, wherein
the reaction product is Caro's acid.

## Patentansprüche

1. Substratreinigungsvorrichtung (1) zum Reinigen eines Substrats (7) unter Verwendung eines Reinigungsmittels, das durch Reaktion mehrerer Arten von chemischen Flüssigkeiten erzeugt wird, wobei die Substratreinigungsvorrichtung umfasst:
eine Mischeinheit (19) zum Mischen einer Mehrzahl von Arten von chemischen Flüssigkeiten;
eine Zufuhreinheit (24) zum Zuführen der chemischen Flüssigkeiten, die von der Mischeinheit gemischt wurden, auf eine Oberfläche eines zu reinigenden Substrats,
eine Heizeinheit (14) zum Heizen der chemischen Flüssigkeiten, die von der Zufuhreinheit auf die Oberfläche des Substrats zugeführt wurden, auf der Oberfläche des Substrats, **dadurch gekennzeichnet, dass**
die Mischeinheit einen Reaktionshemmungsmechanismus (33) zum Hemmen einer Reaktion der gemischten chemischen Flüssigkeiten enthält, bei welcher der Reaktionshemmungsmechanismus als ein Temperaturanstiegs-Hemmungsmechanismus zum Hemmen eines Anstiegs der Temperaturen der gemischten chemischen Flüssigkeiten fungiert.

2. Substratreinigungsvorrichtung nach Anspruch 1, bei welcher
der Temperaturanstiegs-Hemmungsmechanismus ein Kühlmechanismus zum Kühlen der gemischten chemischen Flüssigkeiten ist.

3. Substratreinigungsvorrichtung nach Anspruch 1, bei welcher
das Reinigungsmittel ein Reaktionsprodukt ist, das durch Reagieren von Schwefelsäure und einer Wasserstoffperoxidlösung erzeugt wird, wobei die Substratreinigungsvorrichtung umfasst:
die Mischeinheit zum Mischen von Schwefelsäure und einer Wasserstoffperoxidlösung, um eine Schwefelsäure/Wasserstoffperoxidmischung (SPM) zu erzeugen;
die Zufuhreinheit zum Zuführen der Schwefelsäure/Wasserstoffperoxidmischung, die von der Mischeinheit erzeugt wurde, auf eine Oberfläche eines zu reinigenden Substrats, und
die Heizeinheit zum Heizen der Schwefelsäure/Wasserstoffperoxidmischung, die durch die Zufuhreinheit auf die Oberfläche des Substrats zugeführt wurde, auf der Oberfläche des Substrats.

4. Substratreinigungsvorrichtung nach Anspruch 3, bei welcher
der Temperaturanstiegs-Hemmungsmechanismus aufgebaut ist, um Schwefelsäure und eine Wasserstoffperoxidlösung allmählich zu mischen, um einen Zustand beizubehalten, in dem die Wasserstoffperoxidlösung nicht schäumt.

5. Substratreinigungsvorrichtung nach Anspruch 3, bei welcher
der Temperaturanstiegs-Hemmungsmechanismus ein Kühlmechanismus zum Kühlen der gemischten Schwefelsäure und der Wasserstoffperoxidlösung ist.

6. Substratreinigungsvorrichtung nach Anspruch 5, bei welcher
der Kühlmechanismus aufgebaut ist, um die gemischte Schwefelsäure und die Wasserstoffperoxidlösung auf eine Temperatur zu kühlen, bei der die Wasserstoffperoxidlösung nicht schäumt.

7. Substratreinigungsvorrichtung nach Anspruch 3, bei der
das Reaktionsprodukt eine Carosche Säure ist.

8. Substratreinigungsverfahren zum Reinigen eines Substrats (7) unter Verwendung eines Reinigungsmittels, das durch Reaktion mehrerer Arten von chemischen Flüssigkeiten erzeugt wird, wobei das Substratreinigungsverfahren die Schritte umfasst:
Mischen mehrerer Arten von chemischen Flüssigkeiten;
Zuführen der gemischten chemischen Flüssigkeiten auf eine Oberfläche eines zu reinigenden Substrats; und
Erhitzen der chemischen Flüssigkeiten, die auf die Oberfläche des Substrats zugeführt wurden, auf der Oberfläche des Substrats, **dadurch gekennzeichnet, dass**
beim Schritt des Mischens der mehreren Arten von chemischen Flüssigkeiten eine Reaktion der mehreren Arten von chemischen Flüssigkeiten durch Hemmen eines Anstiegs der Temperaturen der gemischten chemischen Flüssigkeiten gehemmt wird.

9. Substratreinigungsverfahren nach Anspruch 8, bei dem beim Schritt des Mischens der mehreren Arten von chemischen Flüssigkeiten, eine Reaktion der mehreren Arten von chemischen Flüssigkeiten durch Kühlen der mehreren Arten von chemischen Flüssigkeiten gehemmt wird.

10. Substratreinigungsverfahren nach Anspruch 8, bei dem das Reinigungsmittel ein Reaktionsprodukt ist, das durch Reaktion von Schwefelsäure und einer Wasserstoffperoxidlösung erzeugt wird, wobei das Substratreinigungsverfahren die Schritte umfasst:
Mischen von Schwefelsäure und einer Wasserstoffperoxidlösung, um eine Schwefelsäure/Wasserstoffperoxidlösung zu erzeugen;
Zuführen der Schwefelsäure/Wasserstoffperoxidmischung, die erzeugt wurde, auf eine Oberfläche eines zu reinigenden Substrats; und
Erhitzen der Schwefelsäure/Wasserstoffperoxidmischung, die auf die Oberfläche des Substrats zugeführt wurde, auf der Oberfläche des Substrats.

11. Substratreinigungsverfahren nach Anspruch 10, bei dem
beim Schritt des Mischens der Schwefelsäure und der Wasserstoffperoxidlösung ein Anstieg der Temperaturen der gemischten Schwefelsäure und der Wasserstoffperoxidlösung gehemmt wird.

12. Substratreinigungsverfahren nach Anspruch 10, bei dem
beim Schritt des Mischens der Schwefelsäure und der Wasserstoffperoxidlösung ein Anstieg der Temperaturen der Schwefelsäure und der Wasserstoffperoxidlösung durch allmähliches Mischen der Schwefelsäure und der Wasserstoffperoxidlösung gehemmt wird, um einen Zustand beizubehalten, in dem die Wasserstoffperoxidlösung nicht schäumt.

13. Substratreinigungsverfahren nach Anspruch 10, bei dem
beim Schritt des Mischens der Schwefelsäure und der Wasserstoffperoxidlösung ein Anstieg der Temperaturen der Schwefelsäure und der Wasserstoffperoxidlösung durch Kühlen der gemischten Schwefelsäure und der Wasserstoffperoxidlösung auf eine Temperatur, bei der die Wasserstoffperoxidlösung nicht schäumt, gehemmt wird.

14. Substratreinigungsverfahren nach Anspruch 10, bei dem
das Reaktionsprodukt eine Caroesche Säure ist.

15. Speichermittel, das ein Substratreinigungsprogramm speichert, zum Ermöglichen einer Substratreinigungsvorrichtung (1), ein Substrat (7) unter Verwendung eines Reinigungsmittels, das durch Reaktion mehrerer Arten von chemischen Flüssigkeiten erzeugt wird, zu reinigen, um einen Substratreinigungsarbeitsablauf auszuführen, wobei das Substratreinigungsprogramm die Schritte umfasst:
Mischen mehrerer Arten von chemischen Flüssigkeiten;
Zuführen der chemischen Flüssigkeiten auf eine Oberfläche eines zu reinigenden Substrats; und
Erhitzen der chemischen Flüssigkeiten, die auf die Oberfläche des Substrats zugeführt wurden, auf der Oberfläche des Substrats, **dadurch gekennzeichnet, dass** beim Schritt des Mischens der Mehrzahl von Arten von chemischen Flüssigkeiten eine Reaktion der mehreren Arten von chemischen Flüssigkeiten durch Hemmen eines Anstiegs der Temperaturen der gemischten chemischen Flüssigkeiten gehemmt wird.

16. Speichermittel nach Anspruch 15, bei dem
beim Schritt des Mischens der Mehrzahl von Arten von chemischen Flüssigkeiten in dem Substratreinigungsprogramm eine Reaktion der mehreren Arten von chemischen Flüssigkeiten durch Kühlen der mehreren Arten von chemischen Flüssigkeiten gehemmt wird.

17. Speichermittel nach Anspruch 15, bei dem das Reinigungsmittel ein Reaktionsprodukt ist, das durch Reagieren von Schwefelsäure und einer Wasserstoffperoxidlösung erzeugt wird, wobei das Substratreinigungsprogramm die Schritte umfasst:
Mischen von Schwefelsäure und einer Wasserstoffperoxidlösung, um eine Schwefelsäure/Wasserstoffperoxidmischung zu erzeugen;
Zuführen der Schwefelsäure/Wasserstoffperoxidmischung, die erzeugt wurde, auf eine Oberfläche eines zu reinigenden Substrats; und
Erhitzen der Schwefelsäure/Wasserstoffperoxidmischung, die auf die Oberfläche des Substrats zugeführt wurde, auf der Oberfläche des Substrats.

18. Speichermittel nach Anspruch 17, bei dem
beim Schritt des Mischens der Schwefelsäure und der Wasserstoffperoxidlösung in dem Substratreinigungsprogramm ein Anstieg der Temperaturen der gemischten Schwefelsäure und der Wasserstoffperoxidlösung gehemmt wird.

19. Speichermittel nach Anspruch 17, bei dem
beim Schritt des Mischens der Schwefelsäure und der Wasserstoffperoxidlösung in dem Substratreinigungsprogramm, ein Anstieg der Temperaturen der Schwefelsäure und der Wasserstoffperoxidlösung durch allmähliches Mischen der Schwefelsäure und der Wasserstoffperoxidlösung gehemmt wird, um einen Zustand beizubehalten, bei dem die Wasserstoffperoxidlösung nicht schäumt.

20. Speichermittel nach Anspruch 17, bei dem
beim Schritt des Mischens der Schwefelsäure und der Wasserstoffperoxidlösung in dem Substratreinigungsprogramm, ein Anstieg der Temperaturen der Schwefelsäure und Wasserstoffperoxidlösung durch Kühlen der gemischten Schwefelsäure und der Wasserstoffperoxidlösung auf eine Temperatur, bei der die Wasserstoffperoxidlösung nicht schäumt, gehemmt wird.

21. Speichermittel nach Anspruch 17, bei dem
das Reaktionsprodukt eine Caroesche Säure ist.

## Revendications

1. Appareil de nettoyage de substrat (1) pour nettoyer un substrat (7) avec l'utilisation d'un agent de nettoyage qui est généré en faisant réagir plusieurs sortes de liquides chimiques, l'appareil de nettoyage de substrat comprenant :
une unité de mélange (19) pour mélanger plusieurs sortes de liquides chimiques ;
une unité d'approvisionnement (24) pour amener les liquides chimiques, qui ont été mélangés par l'unité de mélange, sur une surface d'un substrat à nettoyer ;
une unité de chauffage (14) pour chauffer les liquides chimiques qui ont été amenés sur la surface du substrat par l'unité d'approvisionnement sur la surface du substrat, **caractérisé en ce que** :
l'unité de mélange inclut un mécanisme de restriction de réaction (33) pour restreindre une réaction des liquides chimiques mélangés, dans laquelle le mécanisme de restriction de réaction fonctionne comme un mécanisme de restriction de hausse de température pour restreindre la hausse de températures des liquides chimiques mélangés.

2. Appareil de nettoyage de substrat selon la revendication 1, dans lequel
le mécanisme de restriction de hausse de température est un mécanisme de refroidissement pour refroidir les liquides chimiques mélangés.

3. Appareil de nettoyage de substrat selon la revendication 1, dans lequel
l'agent de nettoyage est un produit de réaction qui est généré en faisant réagir de l'acide sulfurique et une solution de peroxyde d'hydrogène, l'appareil de nettoyage de substrat comprenant :
l'unité de mélange pour mélanger de l'acide sulfurique et une solution de peroxyde d'hydrogène pour générer un mélange d'acide sulfurique / peroxyde d'hydrogène (SPM) ;
l'unité d'approvisionnement pour amener le mélange d'acide sulfurique / peroxyde d'hydrogène, qui a été généré par l'unité de mélange, sur une surface d'un substrat à nettoyer, et
l'unité de chauffage pour chauffer le mélange d'acide sulfurique / peroxyde d'hydrogène, qui a été amené sur la surface du substrat par l'unité d'approvisionnement, sur la surface du substrat.

4. Appareil de nettoyage de substrat selon la revendication 3, dans lequel
le mécanisme de restriction de hausse de température est configuré pour mélanger graduellement l'acide sulfurique et la solution de peroxyde d'hydrogène afin de maintenir un état dans lequel la solution de peroxyde d'hydrogène ne forme pas de mousse.

5. Appareil de nettoyage de substrat selon la revendication 3, dans lequel le mécanisme de restriction de hausse de température est un mécanisme de refroidissement pour refroidir l'acide sulfurique et la solution de peroxyde d'hydrogène mélangés.

6. Appareil de nettoyage de substrat selon la revendication 5, dans lequel
le mécanisme de refroidissement est configuré pour refroidir l'acide sulfurique et la solution de peroxyde d'hydrogène mélangés jusqu'à une température à laquelle la solution de peroxyde d'hydrogène ne forme pas de mousse.

7. Appareil de nettoyage de substrat selon la revendication 3, dans lequel
le produit de réaction est de l'acide de Caro.

8. Procédé de nettoyage de substrat pour nettoyer un substrat (7) avec l'utilisation d'un agent de nettoyage qui est généré en faisant réagir plusieurs sortes de liquides chimiques, le procédé de nettoyage de substrat comprenant les étapes consistant à :
mélanger plusieurs sortes de liquides chimiques ;
amener les liquides chimiques mélangés sur une surface d'un substrat à nettoyer ; et
chauffer les liquides chimiques, qui ont été amenés sur la surface du substrat, sur la surface du substrat, **caractérisé en ce que**
à l'étape de mélange des plusieurs sortes de liquides chimiques, une réaction des plusieurs sortes de liquides chimiques est restreinte en restreignant la hausse de températures des liquides chimiques mélangés.

9. Procédé de nettoyage de substrat selon la revendication 8, dans lequel
à l'étape de mélange des plusieurs sortes de liquides chimiques, une réaction des plusieurs sortes de liquides chimiques est restreinte en refroidissant les plusieurs sortes de liquides chimiques.

10. Procédé de nettoyage de substrat selon la revendication 8, dans lequel l'agent de nettoyage est un produit de réaction qui est généré en faisant réagir de l'acide sulfurique et une solution de peroxyde d'hydrogène, le procédé de nettoyage de substrat comprenant les étapes consistant à :
mélanger de l'acide sulfurique et une solution de peroxyde d'hydrogène pour générer un mélange d'acide sulfurique / peroxyde d'hydrogène ;
amener le mélange d'acide sulfurique / peroxyde d'hydrogène, qui a été généré, sur une surface d'un substrat à nettoyer ; et
chauffer le mélange d'acide sulfurique / peroxyde d'hydrogène, qui a été amené sur la surface du substrat, sur la surface du substrat.

11. Procédé de nettoyage de substrat selon la revendication 10, dans lequel
à- l'étape -de mélange de l'acide sulfurique et de la solution de peroxyde d'hydrogène, une hausse de températures de l'acide sulfurique et de la solution de peroxyde d'hydrogène mélangés est restreinte.

12. Procédé de nettoyage de substrat selon la revendication 10, dans lequel
à l'étape de mélange de l'acide sulfurique et de la solution de peroxyde d'hydrogène, une hausse de températures de l'acide sulfurique et de la solution de peroxyde d'hydrogène est restreinte en mélangeant graduellement l'acide sulfurique et la solution de peroxyde d'hydrogène afin de maintenir un état dans lequel la solution de peroxyde d'hydrogène ne forme pas de mousse.

13. Procédé de nettoyage de substrat selon la revendication 10, dans lequel
à l'étape de mélange de l'acide sulfurique et de la solution de peroxyde d'hydrogène, une hausse de températures de l'acide sulfurique et de la solution de peroxyde d'hydrogène est restreinte en refroidissant l'acide sulfurique et la solution de peroxyde d'hydrogène mélangés jusqu'à une température à laquelle la solution de peroxyde d'hydrogène ne forme pas de mousse.

14. Procédé de nettoyage de substrat selon la revendication 10, dans lequel le produit de réaction est de l'acide de Caro.

15. Support de stockage stockant un programme de nettoyage de substrat pour permettre à un appareil de nettoyage de substrat (1) pour nettoyer un substrat (7) avec l'utilisation d'un agent de nettoyage qui est généré en faisant réagir plusieurs sortes de liquides chimiques, d'effectuer une opération de nettoyage de substrat, le programme de nettoyage de substrat comprenant les étapes consistant à :
mélanger plusieurs sortes de liquides chimiques ;
amener les liquides chimiques mélangés sur une surface d'un substrat à nettoyer ; et
chauffer les liquides chimiques, qui ont été amenés sur la surface du substrat, sur la surface du substrat, **caractérisé en ce que**
à l'étape de mélange des plusieurs sortes de liquides chimiques, une réaction des plusieurs sortes de liquides chimiques est restreinte en restreignant une hausse de températures des liquides chimiques mélangés.

16. Support de stockage selon la revendication 15, dans lequel
à l'étape de mélange des plusieurs sortes de liquides chimiques dans le programme de nettoyage de substrat, une réaction des plusieurs sortes de liquides chimiques est restreinte en refroidissant les plusieurs sortes de liquides chimiques.

17. Support de stockage selon la revendication 15, dans lequel l'agent de nettoyage est un produit de réaction qui est généré en faisant réagir de l'acide sulfurique et une solution de peroxyde d'hydrogène, le programme de nettoyage de substrat comprenant les étapes consistant à :
mélanger de l'acide sulfurique et une solution de peroxyde d'hydrogène pour générer un mélange d'acide sulfurique / peroxyde d'hydrogène ;
amener le mélange d'acide sulfurique / peroxyde d'hydrogène, qui a été généré, sur une surface d'un substrat à nettoyer ; et
chauffer le mélange d'acide sulfurique / peroxyde d'hydrogène, qui a été amené sur la surface du substrat, sur la surface du substrat.

18. Support de stockage selon la revendication 17, dans lequel
à l'étape de mélange de l'acide sulfurique et de la solution de peroxyde d'hydrogène dans le programme de nettoyage de substrat, une hausse de températures de l'acide sulfurique et de la solution de peroxyde d'hydrogène mélangés est restreinte.

19. Support de stockage selon la revendication 17, dans lequel
à l'étape de mélange de l'acide sulfurique et de la solution de peroxyde d'hydrogène dans le programme de nettoyage de substrat, une hausse de températures de l'acide sulfurique et de la solution de peroxyde d'hydrogène est restreinte en mélangeant graduellement l'acide sulfurique et la solution de peroxyde d'hydrogène afin de maintenir un état dans lequel la solution de peroxyde d'hydrogène ne forme pas de mousse.

20. Support de stockage selon la revendication 17, dans lequel
à l'étape de mélange de l'acide sulfurique et de la solution de peroxyde d'hydrogène dans le programme de nettoyage de substrat, une hausse de températures de l'acide sulfurique et de la solution de peroxyde d'hydrogène est restreinte en refroidissant l'acide sulfurique et la solution de peroxyde d'hydrogène mélangés jusqu'à une température à laquelle la solution de peroxyde d'hydrogène ne forme pas de mousse.

21. Support de stockage selon la revendication 17, dans lequel le produit de réaction est de l'acide de Caro.
